# EUROPEAN PATENT APPLICATION

(11) **EP 4 561 317 A1**
(43) Date of publication of application: **28.05.2025**
(21) Application number: 24214603.3
(22) Date of filing: 21.11.2024
(51) Int. Cl.: H10K 59/122, H10K 59/80

(54) **DISPLAY DEVICE**

(30) Priority: 24.11.2023 KR 20230165333
(71) Applicant: Samsung Display Co., Ltd., Yongin-si, Gyeonggi-do 17113 (KR)
(72) Inventor: KIM, Jae Hyun, Yongin-si (KR); LEE, Che Ho, Yongin-si (KR); JEONG, So Yeon, Yongin-si (KR); JO, Won Je, Yongin-si (KR)
(74) Representative: Marks & Clerk LLP

(57) **Abstract**

A display device includes first and second pixel electrodes spaced apart from each other on a substrate; a pixel defining layer on the substrate, and exposing the first and second pixel electrodes; first and second light emitting layers on the first and second pixel electrodes, respectively; first and second common electrodes on the first and second light emitting layers, respectively, and spaced apart from each other; a first bank on the pixel defining layer; a second bank on the first bank, where a side surface of the second bank protrudes more than a side surface of the first bank; first and second inorganic films on the first and second common electrodes, respectively, and on the second bank, and spaced apart from each other and from a top surface of the second bank. Film qualities of the first inorganic film and the second inorganic film are different from each other.

## Description

### BACKGROUND

### 1. Field

Embodiments of the disclosure relate to a display device.

### 2. Description of the Related Art

With the advance of information-oriented society, demands on display devices for displaying images are increasing in various fields. For example, display devices are employed in various electronic devices such as smartphones, digital cameras, laptop computers, navigation devices, and smart televisions. The display device may be a flat panel display device such as a liquid crystal display device, a field emission display device or an organic light emitting display device. Among various types of flat panel display device, in the light emitting display device, since each of the pixels of a display panel includes a light emitting element capable of emitting light by itself, an image can be displayed without using a backlight unit for providing light to the display panel.

Recently, the display device is employed in a glass-type device for providing virtual reality and augmented reality. In order to be employed in the glass-type device, the display device may be implemented in a very small size of 2 inches or less, or be desired to have a high pixel pitch to be implemented with high resolution. For example, the display device may have a high pixel pitch of 400 pixels per inch (PPI) or greater.

### SUMMARY

In a display device employed in a glass-type device, where the display device is implemented in a very small size or has a high pixel pitch, it may be difficult to implement light emitting elements separated for each emission area by a mask process because the area of the emission area where the light emitting element is disposed is reduced or substantially small.

Embodiments of the disclosure provide a display device capable of forming light emitting elements separated for each emission area without a mask process.

Embodiments of the disclosure also provide a display device with reduced discrepancy in light emission in each pixel, which might be caused as an etchant permeates into a light emitting element in an etching process performed during a manufacturing process of the display device.

However, features of embodiments of the disclosure are not restricted to those set forth herein. The above and other features of embodiments of the disclosure will become more apparent to one of ordinary skill in the art to which the disclosure pertains by referencing the detailed description of the disclosure given below.

According to an embodiment of the disclosure, a display device includes a first pixel electrode and a second pixel electrode disposed to be spaced apart from each other on a substrate; a pixel defining layer disposed on the substrate, where the pixel defining layer exposes the first pixel electrode and the second pixel electrode; a first light emitting layer disposed on the first pixel electrode, and a second light emitting layer disposed on the second pixel electrode; a first common electrode disposed on the first light emitting layer, and a second common electrode disposed on the second light emitting layer and spaced apart from the first common electrode; a first bank disposed on the pixel defining layer; a second bank disposed on the first bank, where a side surface of the second bank protrudes more than a side surface of the first bank; a first inorganic film disposed on the first common electrode and the second bank, and spaced apart from a top surface of the second bank; and a second inorganic film disposed on the second common electrode and the second bank, and spaced apart from the top surface of the second bank and the first inorganic film, where a film quality of the first inorganic film and a film quality of the second inorganic film are different from each other.

In an embodiment, the first inorganic film and the second inorganic film may be different from each other in at least one selected from thickness, material, and refractive index.

In an embodiment, each of the first inorganic film and the second inorganic film may comprise a first layer, a second layer, and a third layer, which are sequentially stacked therein, and the first layer of the first inorganic film and the first layer of the second inorganic film may be in contact with a bottom surface of the first bank.

In an embodiment, one pair among a pair of first layers, a pair of second layers, and a pair of third layers of the first inorganic film and the second inorganic film may include a same material as each other, and another pair among the pair of first layers, the pair of second layers, and the pair of third layers of the first inorganic film and the second inorganic film includes different materials, respectively.

In an embodiment, the second layer of the first inorganic film may include silicon nitride, and the second layer of the second inorganic film may include silicon oxynitride.

In an embodiment, the first light emitting layer may emit blue light, and the second light emitting layer may emit red light or green light.

In an embodiment, the first layer of the first inorganic film may include a same material as the second layer of the first inorganic film and the first layer of the second inorganic film, and the first layer of the first inorganic film may include a material different from a material of the third layer of the first inorganic film and the second layer of the second inorganic film.

In an embodiment, a refractive index of the second layer of the first inorganic film may be greater than a refractive index of the second layer of the second inorganic film, and a refractive index of the first layer of the second inorganic film may be greater than a refractive index of the second layer of the second inorganic film.

In an embodiment, a refractive index of the first layer of the first inorganic film and the refractive index of the second layer of the first inorganic film may be equal to each other, or a difference between the refractive index of the first layer of the first inorganic film and the refractive index of the second layer of the first inorganic film may be equal to or less than 0.1.

In an embodiment, a thickness of the first inorganic film and a thickness of the second inorganic film may be different from each other.

In an embodiment, a thickness of the second layer of the first inorganic film may be greater than a sum of a thickness of the first layer of the first inorganic film and a thickness of the third layer of the first inorganic film.

In an embodiment, the first layer of the first inorganic film may include a same material as the first layer of the second inorganic film, the first layer of the first inorganic film may have a same refractive index, and a same thickness as the first layer of the second inorganic film.

In an embodiment, the first layer of the first inorganic film and the first layer of the second inorganic film may face the side surface of the first bank, a side surface of the second bank, and the top surface of the second bank.

In an embodiment, the display device may further include an organic encapsulation film disposed between the first inorganic film and the top surface of the second bank, and between the second inorganic film and the top surface of the second bank.

According to an embodiment of the disclosure, a display device comprises a first pixel electrode, a second pixel electrode, and a third pixel electrode disposed to be spaced apart from each other on a substrate; a pixel defining layer disposed on the substrate, where the pixel defining layer exposes the first pixel electrode, the second pixel electrode, and the third pixel electrode; a first light emitting layer disposed on the first pixel electrode, a second light emitting layer disposed on the second pixel electrode, and a third light emitting layer disposed on the third pixel electrode; a first common electrode disposed on the first light emitting layer, a second common electrode disposed on the second light emitting layer and spaced apart from the first common electrode, and a third common electrode disposed on the third light emitting layer and spaced apart from the second common electrode; a first bank disposed on the pixel defining layer; a second bank disposed on the first bank, where a side surface of the second bank protrudes more than a side surface of the first bank; a first inorganic film disposed on the first common electrode and the second bank, and spaced apart from a top surface of the second bank; a second inorganic film disposed on the second common electrode and the second bank, and spaced apart from the top surface of the second bank and the first inorganic film; and a third inorganic film disposed on the third common electrode and the second bank, and spaced apart from the top surface of the second bank, the first inorganic film, and the second inorganic film, where the first inorganic film has a film quality different from a film quality of the second inorganic film and a film quality of the third inorganic film.

In an embodiment, the film quality of the second inorganic film and the film quality of the third inorganic film may be different from each other.

In an embodiment, each of the first inorganic film, the second inorganic film, and the third inorganic film may include a first layer, a second layer, and a third layer, which are sequentially stacked therein, and the second layer of the first inorganic film, the second layer of the second inorganic film, and the second layer of the third inorganic film may have refractive indices different from each other.

In an embodiment, the third layer of the first inorganic film, the third layer of the second inorganic film, and the third layer of the third inorganic film include a same material, and the third layer of the first inorganic film, the third layer of the second inorganic film, and the third layer of the third inorganic film may have refractive indices different from each other.

In an embodiment, the film quality of the third inorganic film may be the same as the film quality of the second inorganic film.

In an embodiment, the first layer, the second layer and the third layer of the second inorganic film may be the same as the first layer, the second layer and the third layer of the third inorganic film, respectively.

At least some of the above and other features of the invention are set out in the claims.

A display device according to an embodiment includes multi-layered lower encapsulation films spaced apart for each emission area. In such an embodiment, the lower encapsulation film in one emission area has a different film quality or structure from the lower encapsulation film in another emission area, such that the display device may be allowed to have high efficiency while effectively preventing permeation during a manufacturing process.

However, effects according to the embodiments of the disclosure are not limited to those exemplified above and various other effects are incorporated herein.

### BRIEF DESCRIPTION OF THE DRAWINGS

The above and other features of embodiments of the disclosure will become more apparent by describing in detail embodiments thereof with reference to the accompanying drawings, in which:
FIG. 1 is a perspective view illustrating a display device according to an embodiment;
FIG. 2 is a cross-sectional view of the display device of FIG. 1 viewed from the side;
FIG. 3 is a plan view illustrating the arrangement of a light emitting element, a lower inorganic encapsulation film, and a second bank of a display device according to an embodiment;
FIG. 4 is a cross-sectional view illustrating a part of a display device according to an embodiment;
FIG. 5 is an enlarged view showing a first emission area of FIG. 4 and the surrounding light emitting element layer and thin film encapsulation layer;
FIG. 6 is an enlarged view showing a second emission area of FIG. 4 and the surrounding light emitting element layer and thin film encapsulation layer;
FIG. 7 is an enlarged view showing a third emission area of FIG. 4 and the surrounding light emitting element layer and thin film encapsulation layer;
FIG. 8 is a cross-sectional view schematically showing the first inorganic film, the second inorganic film, and the third inorganic film of the lower inorganic encapsulation film;
FIG. 9 is a cross-sectional view illustrating permeation of an etchant or water into a light emitting element in a display device including a single-layer lower inorganic encapsulation film; and
FIG. 10 is a cross-sectional view regarding permeation prevention in the display device including the multi-layered lower inorganic encapsulation film.

### DETAILED DESCRIPTION

The invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will also be understood that when a layer is referred to as being "on" another layer or substrate, it can be directly on the other layer or substrate, or intervening layers may also be present. In contrast, when an element is referred to as being "directly on" another element, there are no intervening elements present.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments will be described in detail with reference to the accompanying drawings.

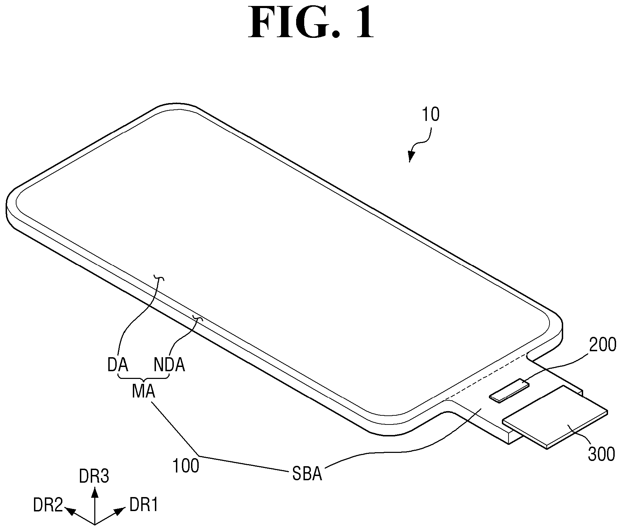

FIG. 1 is a perspective view illustrating a display device according to an embodiment.

Referring to FIG. 1, a display device 10 according to an embodiment may be included in an electronic device and may provide a screen displayed on the electronic device. The electronic device may refer to any electronic device providing a display screen. Examples of the electronic device may include a television, a laptop computer, a monitor, a billboard, an Internet-of-Things device, a mobile phone, a smartphone, a tablet personal computer (PC), an electronic watch, smart glasses, a smart watch, a watch phone, a head-mounted display, a mobile communication terminal, an electronic notebook, an electronic book, a portable multimedia player (PMP), a navigation device, a game machine, a digital camera, a camcorder or the like, which provide a display screen.

The shape of the display device 10 may be variously modified. In an embodiment, for example, the display device 10 may have a shape similar to a rectangular shape having a short side in a first direction DR1 and a long side in a second direction DR2. The edge where the short side in the first direction DR1 and the long side in the second direction DR2 meet may be rounded to have a curvature, but is not limited thereto and may be formed at a right angle. The planar shape of the display device 10 is not limited to a quadrilateral shape, and may be formed in a shape similar to another polygonal shape, a circular shape, or elliptical shape.

In an embodiment, the display device 10 may include a display panel 100, a display driver 200, a circuit board 300, and a touch driver 400.

The display panel 100 may include a main region MA and a sub-region SBA.

The main region MA may include the display area DA including pixels for displaying an image and a non-display area NDA disposed around the display area DA. The display area DA may emit light from a plurality of emission areas or a plurality of opening areas. In an embodiment, for example, the display panel 100 may include a pixel circuit including switching elements, a pixel defining layer defining an emission area or an opening area, and a self-light emitting element.

In an embodiment, for example, the self-light emitting element may include at least one selected from an organic light emitting diode (LED) including an organic light emitting layer, a quantum dot LED including a quantum dot light emitting layer, an inorganic LED including an inorganic semiconductor, and a micro LED, but is not limited thereto.

A plurality of pixels, a plurality of scan lines, a plurality of data lines, and a plurality of power lines may be disposed in the display area DA. Each of the plurality of pixels may define a minimum unit that emits light, and the above-described self-light emitting element may be included in each pixel. The plurality of scan lines may supply a scan signal received from a scan driver to the plurality of pixels. The plurality of data lines may supply the data voltages received from the display driver 200 to the plurality of pixels. The plurality of power lines may supply the power voltages received from the display driver 200 to the plurality of pixels.

The non-display area NDA may be an area outside the display area DA. The non-display area NDA may be defined as an edge area of the main region MA of the display panel 100. The non-display area NDA may include a scan driver that supplies scan signals to the scan lines, and fan-out lines that connect the display driver 200 to the display area DA.

The sub-region SBA may be a region extending from one side of the main region MA. The sub-region SBA may include a flexible material which can be bent, folded or rolled. In an embodiment, for example, where the sub-region SBA is bent, the sub-region SBA may overlap the main region MA in a thickness direction (third direction DR3). The sub-region SBA may include the display driver 200 and a pad portion connected to the circuit board 300. In another embodiment, the sub-region SBA may be omitted, and the display driver 200 and the pad portion may be arranged in the non-display area NDA.

The display driver 200 may output signals and voltages for driving the display panel 100. The display driver 200 may supply data voltages to data lines. The display driver 200 may supply a power voltage to the power line and may supply a scan control signal to the scan driver. The display driver 200 may be formed as an integrated circuit (IC) and mounted on the display panel 100 by a chip on glass (COG) method, a chip on plastic (COP) method, or an ultrasonic bonding method. In an embodiment, for example, the display driver 200 may be disposed in the sub-region SBA, and may overlap the main region MA in the thickness direction (third direction DR3) by bending of the sub-region SBA. In another embodiment, for example, the display driver 200 may be mounted on the circuit board 300.

The circuit board 300 may be attached to the pad portion of the display panel 100 by using an anisotropic conductive film (ACF). Lead lines of the circuit board 300 may be electrically connected to the pad portion of the display panel 100. The circuit board 300 may be a flexible printed circuit board, a printed circuit board, or a flexible film such as a chip on film.

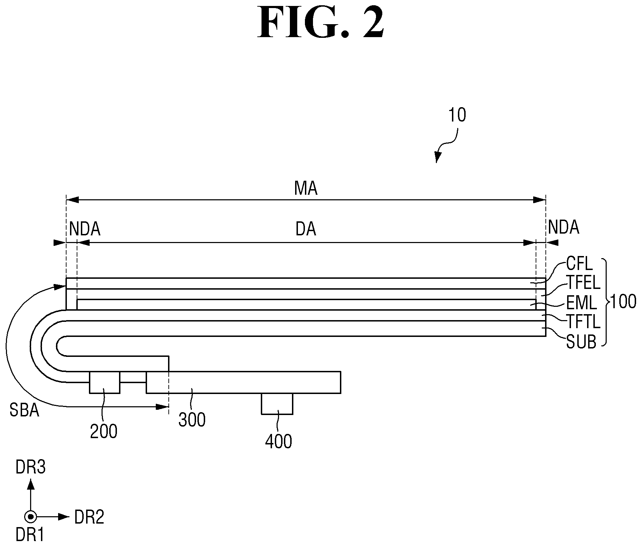

FIG. 2 is a cross-sectional view of the display device of FIG. 1 viewed from the side. Specifically, FIG.2 corresponds to a side view of the display device of FIG. 1 which is in a folded state.

Referring to FIG. 2, in an embodiment, the display panel 100 may include a substrate SUB, a thin film transistor layer TFTL, a light emitting element layer EML, a thin film encapsulation layer TFEL, and a color filter layer CFL.

The substrate SUB may be a base substrate or a base member. The substrate SUB may be a flexible substrate which can be bent, folded or rolled. In an embodiment, for example, the substrate SUB may include a polymer resin such as polyimide (PI), but is not limited thereto. In another embodiment, for example, the substrate SUB may include a glass material or a metal material.

The thin film transistor layer TFTL may be disposed on the substrate SUB. The thin film transistor layer TFTL may include a plurality of thin film transistors constituting a pixel circuit of pixels. The thin film transistor layer TFTL may further include scan lines, data lines, power lines, scan control lines, fan-out lines that connect the display driver 200 to the data lines, and lead lines that connect the display driver 200 to the pad portion. Each of the thin film transistors may include a semiconductor region, a source electrode, a drain electrode, and a gate electrode. In an embodiment, for example, where the scan driver is formed on one side of the non-display area NDA of the display panel 100, the scan driver may include thin film transistors.

The thin film transistor layer TFTL may be disposed in the display area DA, the non-display area NDA, and the sub-region SBA. Thin film transistors, scan lines, data lines, and power lines of each of the pixels of the thin film transistor layer TFTL may be disposed in the display area DA. The scan control lines and fan-out lines of the thin film transistor layer TFTL may be disposed in the non-display area NDA. The lead lines of the thin film transistor layer TFTL may be disposed in the sub-region SBA.

The light emitting element layer EML may be disposed on the thin film transistor layer TFTL. The light emitting element layer EML may include a plurality of light emitting elements each including a first electrode, a second electrode, and a light emitting layer to emit light, and a pixel defining layer defining pixels. The plurality of light emitting elements of the light emitting element layer EML may be disposed in the display area DA.

In an embodiment, the light emitting layer may be an organic light emitting layer including an organic material. The light emitting layer may include a hole transporting layer, an organic light emitting layer, and an electron transporting layer. When the first electrode receives a voltage through the thin film transistor of the thin film transistor layer TFTL and the second electrode receives the cathode voltage, holes and electrons may be transferred to the organic light emitting layer through the hole transporting layer and the electron transporting layer, respectively and may be combined with each other to emit light in the organic light emitting layer.

In another embodiment, the light emitting elements may include a quantum dot LED including a quantum dot light emitting layer, an inorganic LED including an inorganic semiconductor, or a micro LED.

The thin film encapsulation layer TFEL may cover the top surface and the side surface of the light emitting element layer EML, and may protect the light emitting element layer EML. The thin film encapsulation layer TFEL may include at least one inorganic film or/and at least one organic layer for encapsulating the light emitting element layer EML.

The color filter layer CFL may be disposed on the thin film encapsulation layer TFEL. The color filter layer CFL may include a plurality of color filters respectively corresponding to the plurality of emission areas. Each of the color filters may selectively transmit light of a specific wavelength and may block or absorb light of a different wavelength. The color filter layer CFL may absorb a part of light coming from the outside of the display device 10 to reduce reflected light due to external light. Accordingly, the color filter layer CFL may effectively prevent color distortion caused by reflection of the external light.

In an embodiment where the color filter layer CFL is directly disposed on the thin film encapsulation layer TFEL, the display device 10 may not include a separate substrate for the color filter layer CFL. Accordingly, the thickness of the display device 10 may be relatively small.

In some embodiments, the display device 10 may further include an optical device. The optical device may emit or receive light in infrared, ultraviolet, or visible light bands. In an embodiment, for example, the optical device may be an optical sensor that detects light incident on the display device 10 such as a proximity sensor, an illuminance sensor, a camera sensor, a fingerprint sensor, or an image sensor.

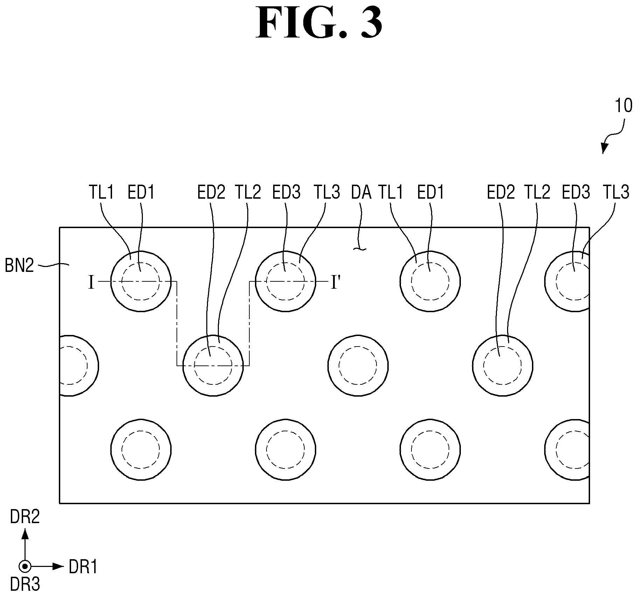

FIG. 3 is a plan view illustrating a part of a display device according to an embodiment. FIG. 3 is a plan view illustrating the layout of light emitting elements ED1, ED2, ED3, lower inorganic encapsulation films TL1, TL2, and TL3, and a second bank BN2 in the display area DA of the display device 10.

Referring to FIG. 3, in an embodiment, the second bank BN2 may cover the display area DA and may expose a part of the display area DA. Openings (indicated by dotted lines in FIG. 3) are defined or formed in regions that are exposed without being covered with the second bank BN2, and the light emitting elements ED1, ED2, and ED3 may be respectively disposed in the openings. The lower inorganic encapsulation films TL1, TL2, and TL3 may cover the boundaries of the openings on the second bank BN2, and may cover the light emitting elements ED1, ED2, and ED3 within the openings.

Although FIG. 3 illustrates an embodiment where the exposed region without being covered with the second bank BN2 is of a circular shape, in another embodiment, the exposed region may have a polygon shape such as a triangle, a square, or a hexagon, and the shape of the lower inorganic encapsulation films TL1, TL2, and TL3 covering the exposed region and the vicinity thereof may also be changed. A portion of each of the lower inorganic encapsulation films TL1, TL2, and TL3 may be disposed at a higher level than the second bank BN2, and the light emitting elements ED1, ED2, and ED3 may be disposed at a lower level than the second bank BN2.

The plurality of light emitting elements ED1, ED2, and ED3 may be arranged in a PenTile^{™} type, e.g., a diamond PenTile^{™} type. In an embodiment, for example, the first light emitting element ED 1 and the third light emitting element ED3 may be disposed to be spaced apart from each other in the first direction DR1, and may be alternately disposed in the first direction DR1 and the second direction DR2. The second light emitting element ED2 may be spaced apart from other adjacent second light emitting elements ED2 in the first direction DR1 and the second direction DR2. The second light emitting element ED2 and the first light emitting element ED1, or the second light emitting element ED2 and the third light emitting element ED3 may be alternately arranged along any direction on a plane formed by the first direction DR1 and the second direction DR2. The shape and the layout of the plurality of light emitting elements and the exposed regions without being covered with the second bank BN2 are not limited to FIG. 3.

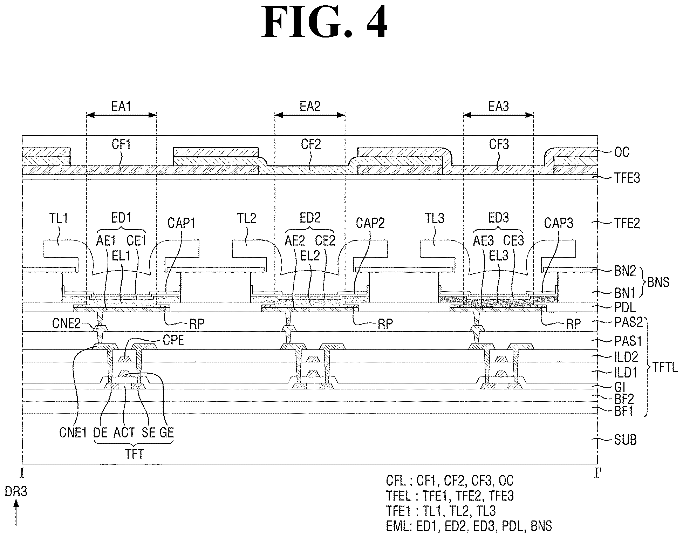

FIG. 4 is a cross-sectional view illustrating a part of a display device according to an embodiment. Specifically, FIG. 4 is a cross-sectional view taken along line I-I' of FIG. 3, and shows the cross sections showing the substrate SUB, the thin film transistor layer TFTL, the light emitting element layer EML, the thin film encapsulation layer TFEL, and the color filter layer CFL of the display panel 100.

The thin film transistor layer TFTL may include a first buffer layer BF1, , a second buffer layer BF2, a thin film transistor TFT, a gate insulating layer GI, a first interlayer insulating layer ILD1, a capacitor electrode CPE, a second interlayer insulating layer ILD2, a first connection electrode CNE1, a first passivation layer PAS1, a second connection electrode CNE2, and a second passivation layer PAS2.

The first buffer layer BF1 may be disposed on the substrate SUB. The first buffer layer BF1 may include an inorganic film capable of preventing penetration of air or water. In an embodiment, for example, the first buffer layer BF1 may include a plurality of inorganic films alternately stacked.

The lower metal layer BML may be disposed on the first buffer layer BF1. In an embodiment, for example, the lower metal layer BML may be formed as a single layer or multiple layers made of or including at least one selected from molybdenum (Mo), aluminium (Al), chromium (Cr), gold (Au), titanium (Ti), nickel (Ni), neodymium (Nd) and copper (Cu) or an alloy thereof.

The second buffer layer BF2 may cover the first buffer layer BF1 and the lower metal layer BML. The second buffer layer BF2 may include an inorganic film capable of preventing penetration of air or water. In an embodiment, for example, the second buffer layer BF2 may include a plurality of inorganic films alternately stacked.

The thin film transistor TFT may be disposed on the second buffer layer BF2, and may constitute a pixel circuit of each of a plurality of pixels. In an embodiment, for example, the thin film transistor TFT may be a switching transistor or a driving transistor of the pixel circuit. The thin film transistor TFT may include a semiconductor layer ACT, a source electrode SE, a drain electrode DE, and a gate electrode GE.

The semiconductor layer ACT may be disposed on the second buffer layer BF2. The semiconductor layer ACT may overlap the lower metal layer BML and the gate electrode GE in the thickness direction DR3, and may be insulated from the gate electrode GE by the gate insulating layer GI. In a part of the semiconductor layer ACT, a material of the semiconductor layer ACT may be made into a conductor to form the source electrode SE and the drain electrode DE.

The gate electrode GE may be disposed on the gate insulating layer GI. The gate electrode GE may overlap the semiconductor layer ACT in the thickness direction DR3 with the gate insulating layer GI interposed therebetween.

The gate insulating layer GI may be disposed on the semiconductor layer ACT. In an embodiment, for example, the gate insulating layer GI may cover the semiconductor layer ACT and the second buffer layer BF2 to insulate the gate electrode GE from the semiconductor layer ACT. The gate insulating layer GI may include a contact hole through which the first connection electrode CNE1 passes.

The first interlayer insulating layer ILD1 may cover the gate electrode GE and the gate insulating layer GI. The first interlayer insulating layer ILD1 may be provided with a contact hole through which the first connection electrode CNE1 passes. The contact hole of the first interlayer insulating layer ILD1 may be connected to the contact hole of the gate insulating layer GI and the contact hole of the second interlayer insulating layer ILD2.

The capacitor electrode CPE may be disposed on the first interlayer insulating layer ILD1. The capacitor electrode CPE may overlap the gate electrode GE in the thickness direction DR3. The capacitor electrode CPE and the gate electrode GE may form a capacitance.

The second interlayer insulating layer ILD2 may cover the capacitor electrode CPE and the first interlayer insulating layer ILD1. The second interlayer insulating layer ILD2 may be provided with a contact hole through which the first connection electrode CNE1 passes. The contact hole of the second interlayer insulating layer ILD2 may be connected to the contact hole of the first interlayer insulating layer ILD1 and the contact hole of the gate insulating layer GI.

The first connection electrode CNE1 may be disposed on the second interlayer insulating layer ILD2. The first connection electrode CNE1 may electrically connect the drain electrode DE of the thin film transistor TFT to the second connection electrode CNE2. The first connection electrode CNE1 may be inserted into a contact hole provided in the second interlayer insulating layer ILD2, the first interlayer insulating layer ILD1, and the gate insulating layer GI to be in contact with the drain electrode DE of the thin film transistor TFT.

The first passivation layer PAS1 may cover the first connection electrode CNE1 and the second interlayer insulating layer ILD2. The first passivation layer PAS1 may protect the thin film transistor TFT. The first passivation layer PAS1 may include a contact hole through which the second connection electrode CNE2 passes.

The second connection electrode CNE2 may be disposed on the first passivation layer PAS 1. The second connection electrode CNE2 may electrically connect the first connection electrode CNE1 to pixel electrodes AE1, AE2, and AE3 of the light emitting elements ED1, ED2, and ED3. The second connection electrode CNE2 may be inserted into a contact hole formed in the first passivation layer PAS1 to be in contact with the first connection electrode CNE1.

The second passivation layer PAS2 may cover the second connection electrode CNE2 and the first passivation layer PAS1. The second passivation layer PAS2 may be provided with a contact hole through which the pixel electrodes AE1, AE2, and AE3 of the light emitting elements ED1, ED2, and ED3 pass.

The light emitting element layer EML may be disposed on the thin film transistor layer TFTL. The light emitting element layer EML may include the light emitting elements ED1, ED2, and ED3, the pixel defining layer PDL, a capping layer CAP, and a bank structure BNS. The light emitting elements ED1, ED2, and ED3 may include pixel electrodes AE1, AE2, and AE3, light emitting layers EL1, EL2, and EL3, and common electrodes CE1, CE2, and CE3, which are sequentially stacked therein.

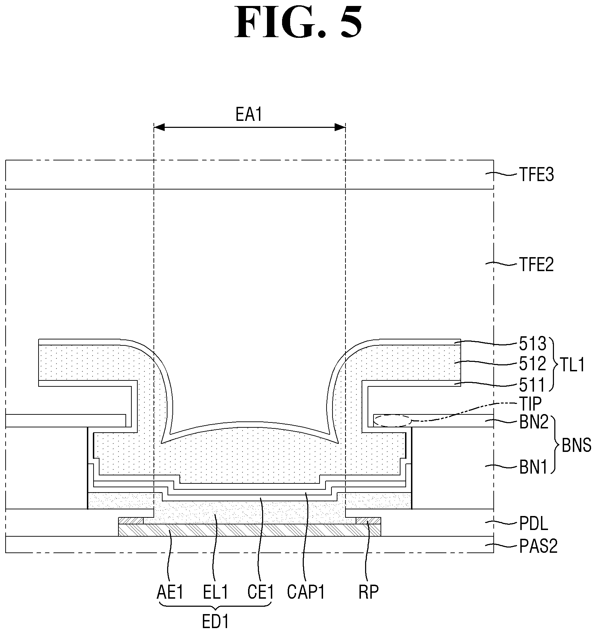

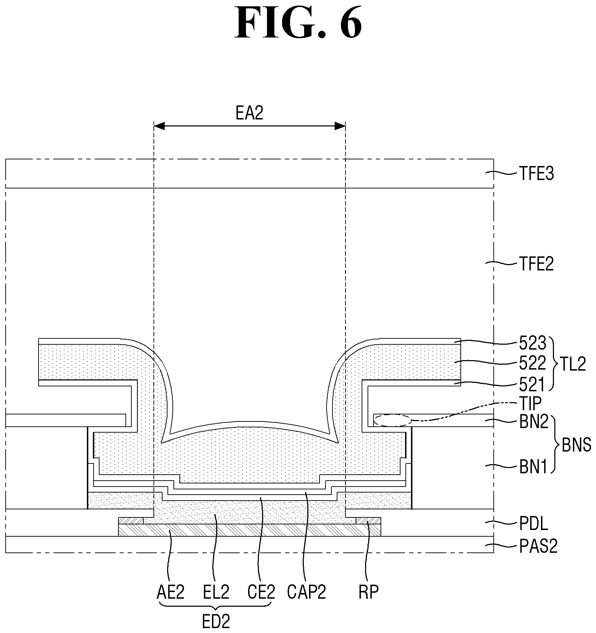

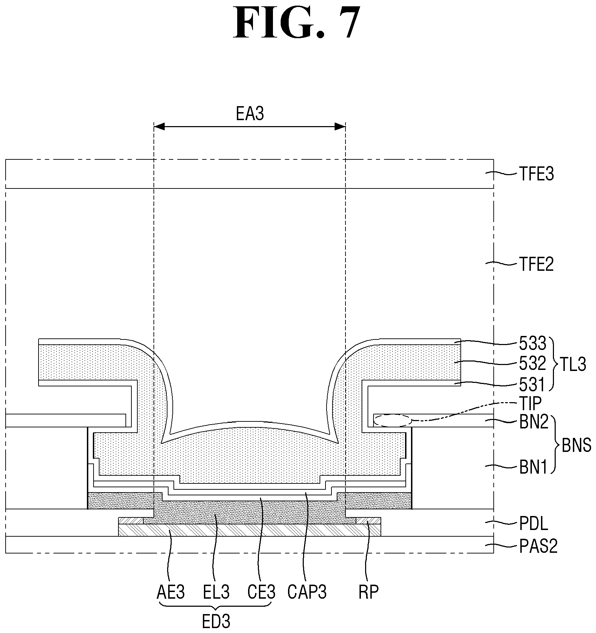

FIG. 5 is an enlarged view showing a first emission area EA1 of FIG. 4 and the surrounding light emitting element layer EML and thin film encapsulation layer TFEL, FIG. 6 is an enlarged view showing a second emission area EA2 of FIG. 4 and the surrounding light emitting element layer EML and thin film encapsulation layer TFEL, and FIG. 7 is an enlarged view showing a third emission area EA3 of FIG. 4 and the surrounding light emitting element layer EML and thin film encapsulation layer TFEL.

Referring to FIGS. 5 to 7 in conjunction with FIG. 4, the display device 10 may include a plurality of emission areas EA1, EA2, and EA3 disposed in the display area DA. The emission areas EA1, EA2, and EA3 may include an area where light is emitted from the light emitting elements ED1, ED2, and ED3 and passes through the color filter layer CFL in the third direction DR3. The emission areas EA1, EA2, and EA3 may include the first emission area EA1, the second emission area EA2, and the third emission area EA3 spaced apart from each other and emitting light of the same or different colors.

In an embodiment, the areas or sizes of the first to third emission areas EA1, EA2, and EA3 may be the same as each other. In an embodiment, for example, in the display device 10, the first emission area EA1, the second emission area EA2, and the third emission area EA3 may have the same area. However, the disclosure is not limited thereto. In an embodiment of the display device 10, the areas or sizes of the first to third emission areas EA1, EA2, and EA3 may be different from each other. In an embodiment, for example, the area of the second emission area EA2 may be greater than the areas of the first emission area EA1 and the third emission area EA3, and the area of the third emission area EA3 may be greater than the area of the first emission area EA1. The intensity of light emitted from the corresponding emission areas EA1, EA2, and EA3 may vary according to the areas of the emission areas EA1, EA2, and EA3, and the areas of the emission areas EA1, EA2, and EA3 may be adjusted to control the color of the screen displayed on the display device 10. Although FIG. 4 illustrates an embodiment where the emission areas EA1, EA2, and EA3 have the same area as each other, the disclosure is not limited thereto.

In an embodiment of the display device 10, one first emission area EA1, one second emission area EA2, and one third emission area EA3 disposed adjacent to each other may form one pixel group. One pixel group may include the emission areas EA1, EA2, and EA3 emitting light of different colors to express a white grayscale. However, the disclosure is not limited thereto, and the combination of the emission areas EA1, EA2, and EA3 constituting one pixel group may be variously modified depending on the arrangement of the emission areas EA1, EA2, and EA3, the color of the light emitted from the emission areas EA1, EA2, and EA3, and the like.

A plurality of openings defined or formed in the bank structure BNS of the light emitting element layer EML are provided along the boundary of the bank structure BNS. A first bank BN1 and the second bank BN2 of the bank structure BNS may surround the emission areas EA1, EA2, and EA3. The opening may include the first to third emission areas EA1, EA2, and EA3.

The display device 10 may include the plurality of light emitting elements ED1, ED2, and ED3 disposed in the different emission areas EA1, EA2, and EA3. The light emitting elements ED1, ED2, and ED3 may include the first light emitting element ED1 disposed in the first emission area EA1, the second light emitting element ED2 disposed in the second emission area EA2, and the third light emitting element ED3 disposed in the third emission area EA3.

The light emitting elements ED1, ED2, and ED3 may include the pixel electrodes AE1, AE2, and AE3, the light emitting layers EL1, EL2, and EL3, and the common electrodes CE1, CE2, and CE3, respectively, and the light emitting layers EL1, EL2, and EL3 disposed in the different emission areas EA1, EA2, and EA3 may emit light of different colors depending on the materials of the light emitting layers EL1, EL2, and EL3. In an embodiment, for example, the first light emitting element ED1 disposed in the first emission area EA1 may emit first light of a blue color having a peak wavelength in a range of 440 nanometers (nm) to 480 nm, the second light emitting element ED2 disposed in the second emission area EA2 may emit second light of a green color having a peak wavelength in a range of 510 nm to 550 nm, and the third light emitting element ED3 disposed in the third emission area EA3 may emit third light of a red color having a peak wavelength in a range of 610 nm to 650 nm. The first to third emission areas EA1, EA2, and EA3 constituting one pixel may respectively include the light emitting elements ED1, ED2, and ED3 emitting light of different colors to express a white grayscale. Alternatively, the light emitting layers EL1, EL2, and EL3 may include two or more materials emitting light of different colors, so that one light emitting layer may emit mixed light. In an embodiment, for example, the light emitting layers EL1, EL2, and EL3 may include a red light emitting material and a green light emitting material to emit yellow light, or may include the red light emitting material, the green light emitting material, and a blue light emitting material to emit white light.

The pixel electrodes AE1, AE2, and AE3 may be disposed on the second passivation layer PAS2. The pixel electrodes AE1, AE2, and AE3 may be disposed in (or to overlap) the plurality of emission areas EA1, EA2, and EA3, respectively. The pixel electrodes AE1, AE2, and AE3 may include a first pixel electrode AE1 disposed in the first emission area EA1, a second pixel electrode AE2 disposed in the second emission area EA2, and a third pixel electrode AE3 disposed in the third emission area EA3. The first pixel electrode AE1, the second pixel electrode AE2, and the third pixel electrode AE3 may be disposed to be spaced apart from each other on the second passivation layer PAS2.

The pixel electrodes AE1, AE2, and AE3 may be electrically connected to the drain electrode DE of the thin film transistor TFT through the first and second connection electrodes CNE1 and CNE2. The edges of the pixel electrodes AE1, AE2, and AE3 spaced apart from each other may be covered by the pixel defining layer PDL, so that the first to third pixel electrodes AE1, AE2, and AE3 may be insulated from each other.

The pixel electrodes AE1, AE2, and AE3 may include a transparent electrode material or/and a conductive metal material. The metal material may be at least one selected from silver (Ag), copper (Cu), aluminium (Al), nickel (Ni), lanthanum (La), titanium (Ti), and titanium nitride (TiN). The transparent electrode material may be at least one selected from indium tin oxide (ITO), indium zinc oxide (IZO), and indium tin zinc oxide (ITZO). The pixel electrodes AE1, AE2, and AE3 may have a multilayer structure of a transparent electrode material and a conductive metal material.

The pixel defining layer PDL may be disposed on the second passivation layer PAS2, a residual pattern RP, and the pixel electrodes AE1, AE2, and AE3. The pixel defining layer PDL may be disposed on the entire second passivation layer PAS2, and may cover the side surfaces of the pixel electrodes AE1, AE2, and AE3 and the residual pattern RP to partially expose the top surfaces of the pixel electrodes AE1, AE2, and AE3. In an embodiment, for example, the pixel defining layer PDL may expose the first pixel electrode AE1 in the first emission area EA1, and the first light emitting layer EL1 may be directly disposed on the first pixel electrode AE1.

The pixel defining layer PDL may include an inorganic insulating material. The pixel defining layer PDL may include at least one selected from silicon nitride, silicon oxynitride, silicon oxide, titanium oxide, aluminium oxide, tantalum oxide, hafnium oxide, zinc oxide, and amorphous silicon, but the disclosure is not limited thereto.

In accordance with an embodiment, the pixel defining layer PDL may be disposed on the pixel electrodes AE1, AE2, and AE3, and may be spaced apart from the top surfaces of the pixel electrodes AE1, AE2, and AE3. The pixel defining layer PDL may partially overlap the top surfaces of the pixel electrodes AE1, AE2, and AE3 in the thickness direction DR3 of the substrate SUB but may not be in direct contact with them, and the residual pattern RP may be disposed between the pixel defining layer PDL and the pixel electrodes AE1, AE2, and AE3. However, the pixel defining layer PDL may be in direct contact with the side surfaces of the pixel electrodes AE1, AE2, and AE3. The side surface of the pixel defining layer PDL may protrude more towards the emission areas EA1, EA2, and EA3 than the side surface of the second bank BN2.

The residual pattern RP may be disposed on the edge of each of the pixel electrodes AE1, AE2, and AE3. The pixel defining layer PDL may not be in direct contact with the top surfaces of the pixel electrodes AE1, AE2, and AE3 due to the residual pattern RP. The residual pattern RP may be formed by removing a part of a sacrificial layer disposed on the pixel electrodes AE1, AE2, and AE3 in the manufacturing process of the display device 10. The residual pattern RP may include a metal or oxide semiconductor material. In the drawings, an embodiment where only the side surface of the residual pattern RP facing the emission areas EA1, EA2, and EA3 is illustrated as being recessed as compared to the side surface of the pixel defining layer PDL, but the disclosure is not limited thereto. The side surface of the residual pattern RP may protrude from the side surface of the pixel defining layer PDL towards the emission areas EA1, EA2, and EA3, or may be aligned with the side surface of the pixel defining layer PDL.

The light emitting layers EL1, EL2, and EL3 may be disposed on the pixel electrodes AE1, AE2, and AE3, respectively. The light emitting layers EL1, EL2, and EL3 may be organic light emitting layers including or made of an organic material, and may be formed on the pixel electrodes AE1, AE2, and AE3, respectively, by a deposition process. The light emitting layers EL1, EL2, and EL3 may have a multilayer structure, and each of a hole injection material, a hole transport material, a light emitting material, an electron transport material, and/or an electron injection material may form or collectively define each of the light emitting layers EL1, EL2, and EL3. When the thin film transistor TFT applies a predetermined voltage to the pixel electrodes AE1, AE2, and AE3 of the light emitting elements ED1, ED2, and ED3, and the common electrodes CE1, CE2, and CE3 of the light emitting elements ED1, ED2, and ED3 receive a common voltage or a cathode voltage, holes and electrons may be injected and transported, and may be combined with each other to emit light in the light emitting layers EL1, EL2, and EL3.

The light emitting layers EL1, EL2, and EL3 may include the first light emitting layer EL1, the second light emitting layer EL2, and the third light emitting layer EL3 disposed in the different emission areas EA1, EA2, and EA3, respectively. The first light emitting layer EL1 may be disposed on the first pixel electrode AE1 in the first emission area EA1, the second light emitting layer EL2 may be disposed on the second pixel electrode AE2 in the second emission area EA2, and the third light emitting layer EL3 may be disposed on the third pixel electrode AE3 in the third emission area EA3. The plurality of light emitting layers EL1, EL2, and EL3 may emit light of different colors, or one light emitting layer EL1, EL2, EL3 may emit mixed light. In an embodiment, the first light emitting layer EL1 may emit blue light having a peak wavelength in the range of 440 nm to 480 nm, the second light emitting layer EL2 may emit green light having a peak wavelength in the range of 510 nm to 550 nm, and the third light emitting layer EL3 may emit red light having a peak wavelength in the range of 610 nm to 650 nm. In another embodiment, the first light emitting layer EL1 may emit blue light, and the second light emitting layer EL2 may emit yellow light, which is a mixture of red light and green light. In another embodiment, the first light emitting layer EL1 may emit white light, which is a mixture of red light, green light, and blue light.

The light emitting layers EL1, EL2, and EL3 may be disposed on the top surface of the pixel defining layer PDL. In an embodiment, the light emitting layers EL1, EL2, and EL3 may be disposed in the space between the pixel electrodes AE1, AE2, and AE3 and the pixel defining layer PDL. In an embodiment, the light emitting layers EL1, EL2, and EL3 may be in contact with the pixel defining layer PDL, the residual pattern RP, and the pixel electrodes AE1, AE2, and AE3.

The common electrodes CE1, CE2, and CE3 may be disposed on the light emitting layers EL1, EL2, and EL3, respectively. The common electrodes CE1, CE2, and CE3 may include a transparent conductive material, so that the light generated in the light emitting layers EL1, EL2, and EL3 may be emitted. The common electrodes CE1, CE2, and CE3 may receive a common voltage or a low potential voltage. When the pixel electrodes AE1, AE2, and AE3 receive the voltage corresponding to a data voltage and the common electrodes CE1, CE2, and CE3 receive the low potential voltage, a potential difference is formed between the pixel electrodes AE1, AE2, and AE3 and the common electrodes CE1, CE2, and CE3, so that the light emitting layers EL1, EL2, and EL3 may emit light.

The common electrodes CE1, CE2, and CE3 may include the first common electrode CE1, the second common electrode CE2, and the third common electrode CE3 disposed in the different emission areas EA1, EA2, and EA3, respectively. The first common electrode CE1 may be disposed on the first light emitting layer EL1 in the first emission area EA1, the second common electrode CE2 may be disposed on the second light emitting layer EL2 in the second emission area EA2, and the third common electrode CE3 may be disposed on the third light emitting layer EL3 in the third emission area EA3. The first to third common electrodes CE1, CE2, and CE3 may be spaced apart from each other.

Capping layers CAP1, CAP2, and CAP3 may be disposed on the common electrodes CE1, CE2, and CE3, respectively. The capping layers CAP1, CAP2, and CAP3 may include an organic material or an inorganic insulating material, and may have a single-layer or multilayer structure. The capping layers CAP1, CAP2, and CAP3 may prevent the light emitting elements ED1, ED2, and ED3 from being damaged by external air. In an embodiment, the capping layers CAP1, CAP2, and CAP3 may include an organic material such as α-NPD, NPB, TPD, m-MTDATA, Alq₃, LiF, and/or CuPc, or an inorganic material such as aluminium oxide, titanium oxide, tantalum oxide, hafnium oxide, zinc oxide, silicon oxide, silicon nitride, and/or silicon oxynitride.

The capping layers CAP1, CAP2, and CAP3 may include a first capping layer CAP1, a second capping layer CAP2, and a third capping layer CAP3 disposed in the different emission areas EA1, EA2, and EA3, respectively. The first to third capping layers CAP1, CAP2, and CAP3 may be spaced apart from each other.

The display device 10 may include the plurality of bank structures BNS disposed on the pixel defining layer PDL. The bank structure BNS may have a structure in which the banks BN1 and BN2 including different materials are sequentially stacked, may include the plurality of openings including the emission areas EA1, EA2, and EA3, and may be disposed to overlap the light blocking layer (not shown) to be described later. The light emitting elements ED1, ED2, and ED3 of the display device 10 may be disposed to overlap the openings of the bank structure BNS.

The bank structure BNS may include the first bank BN1 and the second bank BN2 sequentially stacked on the pixel defining layer PDL.

The first bank BN1 may be disposed on the pixel defining layer PDL. The side surface of the first bank BN1 may be recessed more than the side surface of the pixel defining layer PDL in a direction opposite to a direction facing the emission areas EA1, EA2, and EA3, that is, a direction towards a center of a corresponding emission area among the emission areas EA1, EA2, and EA3. The side surface of the first bank BN1 may be recessed more than the side surface of the second bank BN2 to be described later in a direction opposite to the direction facing the emission areas EA1, EA2, and EA3.

In accordance with an embodiment, the first bank BN1 may include a metal material. In an embodiment, for example, the first bank BN1 may include aluminium (Al) or an alloy of aluminium (Al).

In an embodiment, the thickness of the first bank BN1 may be in a range of 4000 angstrom (Å) to 7000 Å. When the above range is satisfied, it is possible to form the light emitting layers EL1, EL2, and EL3 and the common electrodes CE1, CE2, and CE3 that are spaced apart from each other by a deposition and etching process instead of a mask process.

In accordance with an embodiment, the common electrodes CE1, CE2, and CE3 may be in direct contact with the side surface of the first bank BN1. The common electrodes CE1, CE2, and CE3 of the different light emitting elements ED1, ED2, and ED3 may be in direct contact with the first bank BN1, the first bank BN1 may include a metal material, and the common electrodes CE1, CE2, and CE3 may be electrically connected to each other through the first bank BN1.

The light emitting layers EL1, EL2, and EL3 may be in direct contact with the side surface of the first bank BN1. The contact area between the common electrodes CE1, CE2, and CE3 and the side surface of the first bank BN1 may be greater than the contact area between the light emitting layers EL1, EL2, and EL3 and the side surface of the first bank BN1. The common electrodes CE1, CE2, and CE3 may be disposed in larger areas on the side surface of the first bank BN1 compared to the light emitting layers EL1, EL2, and EL3, or may be disposed at higher positions on the side surface of the first bank BN1 compared to the light emitting layers EL1, EL2, and EL3. Since the common electrodes CE1, CE2, and CE3 of the different light emitting elements ED1, ED2, and ED3 are electrically connected to each other through the first bank BN1, the common electrodes CE1, CE2, and CE3 may be allowed to be in contact with the first bank BN1 in larger areas.

The second bank BN2 may be disposed on the first bank BN1. The second bank BN2 may include a tip TIP that is an area protruding more than the first bank BN1 towards a center of a corresponding emission area among the emission areas EA1, EA2, and EA3. The side surface of the second bank BN2 may protrude more towards the emission areas EA1, EA2, and EA3 than the side surface of the first bank BN1.

As the side surface of the second bank BN2 has a shape protruding more towards a center of a corresponding emission area among the emission areas EA1, EA2, and EA3 than the side surface of the first bank BN1, an undercut structure of the first bank BN1 may be formed under the tip TIP of the second bank BN2.

In the display device 10 according to an embodiment, as the bank structure BNS includes the tip TIP protruding towards a center of a corresponding emission area among the emission areas EA1, EA2, and EA3, the light emitting layers EL1, EL2, and EL3 and the common electrodes CE1, CE2, and CE3 may be formed through deposition and etching processes instead of a mask process. Further, it is possible to individually form different layers in the different emission areas EA1, EA2, and EA3 by the deposition process. In an embodiment, for example, even when the light emitting layers EL1, EL2, and EL3 of the light emitting elements ED1, ED2, and ED3 and the common electrodes CE1, CE2, and CE3 are formed by a deposition process using no mask, the deposited materials may be disconnected by the bank structure BNS interposed therebetween by the tip TIP of the second bank BN2 without being connected between the emission areas EA1, EA2, and EA3. By a process of forming a material for forming a specific layer on the entire surface of the display device 10 and then removing the layer formed in an undesired region by etching, it is possible to individually form different layers in the different emission areas EA1, EA2, and EA3. In an embodiment of the display device 10, the different light emitting elements ED1, ED2, and ED3 may be formed in the different emission areas EA1, EA2, and EA3 by the deposition and etching process without using the mask process, and a component provided in the display device 10 for the mask process may be omitted to minimize the area of the non-display area NDA.

The side shape of the bank structure BNS may be a structure formed by a difference in etching rates in an etching process due to different materials of the first bank BN1 and the second bank BN2. According to an embodiment, the second bank BN2 may include a material having a slower etching rate than the first bank BN1, and the first bank BN1 may be further etched during the etching process to expose the bottom surface of the tip TIP of the second bank BN2, so that an undercut may be formed under the second bank BN2.

The second bank BN2 may include a metal material different from the metal material of the first bank BN1. In an embodiment, for example, the metal material of the second bank BN2 may be a material that is removed by dry etching together with the metal material of the first bank BN1, but has an etching rate much slower than that of the first bank BN1 when wet-etched or is not etched by wet etching. In an embodiment, the first bank BN1 may include aluminium (Al) or an alloy of aluminium (Al), and the second bank BN2 may include titanium (Ti) or an alloy of titanium (Ti).

The tip TIP of the second bank BN2 may overlap the common electrodes CE1, CE2, and CE3 in the direction DR3 perpendicular to the substrate SUB. Further, the tip TIP of the second bank BN2 may overlap the light emitting layers EL1, EL2, and EL3 in the direction DR3 perpendicular to the substrate SUB. Further, the tip TIP of the second bank BN2 may overlap the pixel defining layer PDL in the direction DR3 perpendicular to the substrate SUB. The common electrodes CE1, CE2, and CE3 may be formed under the bottom surface of the tip TIP of the second bank BN2. One end and the other end of each of the common electrodes CE1, CE2, and CE3 may overlap the second bank BN2 in the thickness direction DR3 of the substrate. The maximum vertical distance from the substrate SUB to the common electrodes CE1, CE2, and CE3 may be smaller than the maximum vertical distance from the substrate SUB to the top surface of the first bank BN1.

The thin film encapsulation layer TFEL may be disposed on the light emitting elements ED1, ED2, and ED3 and the bank structure BNS, and may cover the plurality of light emitting elements ED1, ED2, and ED3 and the bank structure BNS. The thin film encapsulation layer TFEL may include at least one inorganic film to prevent oxygen or water from permeating into the light emitting element layer EML. The thin film encapsulation layer TFEL may include at least one organic layer to protect the light emitting element layer EML from foreign substances such as dust.

In an embodiment, the thin film encapsulation layer TFEL may include a lower inorganic encapsulation film TFE1, an organic encapsulation film TFE2, and an upper inorganic encapsulation film TFE3 that are sequentially stacked.

Each of the lower inorganic encapsulation film TFE1 and the upper inorganic encapsulation film TFE3 may include at least one inorganic insulating material. The inorganic insulating material may include at least one selected from aluminium oxide, titanium oxide, tantalum oxide, hafnium oxide, zinc oxide, silicon oxide, silicon nitride, and silicon oxynitride, for example.

The organic encapsulation film TFE2 may include a polymer-based material. Examples of the polymer-based material may include acrylic resin, epoxy resin, polyimide, polyethylene and the like. In an embodiment, the organic encapsulation film TFE2 may include an acrylic resin, for example, polymethyl methacrylate, polyacrylic acid, or the like. The organic encapsulation film TFE2 may be formed by curing a monomer or applying a polymer.

The lower inorganic encapsulation film TFE1 may be disposed on the light emitting elements ED1, ED2, and ED3, and the bank structure BNS. The lower inorganic encapsulation film TFE1 may include a first inorganic film TL1, a second inorganic film TL2, and a third inorganic film TL3 disposed to correspond to the different emission areas EA1, EA2, and EA3, respectively. The first inorganic film TL1, the second inorganic film TL2, and the third inorganic film TL3 may include an inorganic insulating material to cover the light emitting elements ED1, ED2, and ED3, respectively. The first inorganic film TL1, the second inorganic film TL2, and the third inorganic film TL3 may effectively prevent the light emitting elements ED1, ED2, and ED3 from being damaged by external air.

Since the lower inorganic encapsulation film TFE1 (TL1, TL2, TL3) may be formed through a chemical vapor deposition (CVD) method, it may be formed along a step difference of a layer to be deposited. In an embodiment, for example, the first inorganic film TL1, the second inorganic film TL2, and the third inorganic film TL3 may form thin films even under the undercut by the tip TIP of the bank structure BNS. The lower encapsulation films TL1, TL2, and TL3 may be disposed along the top, side, and bottom surfaces of the second bank BN2, the side surface of the first bank BN1, and the top surfaces of the common electrodes CE1, CE2, and CE3.

The lower inorganic encapsulation film TFE1 may include the plurality of inorganic films TL1, TL2, and TL3 spaced apart from each other, and the inorganic films TL1, TL2, and TL3 may be disposed in the emission areas EA1, EA2, and EA3, respectively. The first inorganic film TL1 may be disposed only on the first light emitting element ED1 and the bank structure BNS in the vicinity thereof without overlapping the second light emitting element ED2 and the third light emitting element ED3. The second inorganic film TL2 may be disposed only on the second light emitting element ED2 and the bank structure BNS in the vicinity thereof without overlapping the first light emitting element ED1 and the third light emitting element ED3. The third inorganic film TL3 may be disposed only on the third light emitting element ED3 and the bank structure BNS in the vicinity thereof without overlapping the first light emitting element ED1 and the second light emitting element ED2.

The first inorganic film TL1 may be formed after the first common electrode CE1 is formed, the second inorganic film TL2 may be formed after the second common electrode CE2 is formed, and the third inorganic film TL3 may be formed after the third common electrode CE3 is formed. The first inorganic film TL1, the second inorganic film TL2, and the third inorganic film TL3 may be spaced apart from each other on the bank structure BNS.

The lower encapsulation films TL1, TL2, and TL3 may cover the light emitting elements ED1, ED2, and ED3 and the second bank BN2 in the vicinity thereof, while being spaced apart from the top surface of the second bank BN2. The organic encapsulation film TFE2 may be disposed in a space between the lower encapsulation films TL1, TL2, and TL3 and the top surface of the second bank.

In an embodiment, one of the first to third inorganic films TL1 to TL3 may have a film quality (i.e., distinguishing characteristic, property or attribute) different from a film quality of another of the first to third inorganic films TL1 to TL3. In an embodiment, for example, one of the first to third inorganic films TL1 to TL3 may have a material and/or physical property (refractive index, thickness, etc.) different from that of another of the first to third inorganic films TL1 to TL3. In an embodiment, two of the first to third inorganic films TL1 to TL3 may have a same material as each other but different refractive indexes from each other. Alternatively, two of the first to third inorganic films TL1 to TL3 may have a same refractive index as each other but different thicknesses from each other. Each of the first to third inorganic films TL1 to TL3 may include several materials, and when some of the materials of one layer are not common to those of the other layers, the materials of the two layers may be understood as being different from each other.

Two of the first to third inorganic films TL1 to TL3 may have a same film quality as each other, while the other of the first to third inorganic films TL1 to TL3 may have a different film quality. In an embodiment, for example, the first inorganic film TL1 may have a film quality different from that of the second inorganic film TL2 and the third inorganic film TL3, whereas the second inorganic film TL2 and the third inorganic film TL3 may have a same film quality as each other. Alternatively, the film qualities of the first to third inorganic films TL1 to TL3 may be different from each other. The first inorganic film TL1 and the second inorganic film TL2 may be different from each other in at least one of thickness, material, or refractive index. In addition, the third inorganic film TL3 may be different from the first inorganic film TL1 and the second inorganic film TL2 in at least one selected from thickness, material, and refractive index, or all of the thickness, the material, and the refractive index of the third inorganic film TL3 may be the same as those of one of the first inorganic film TL1 and the second inorganic film TL2.

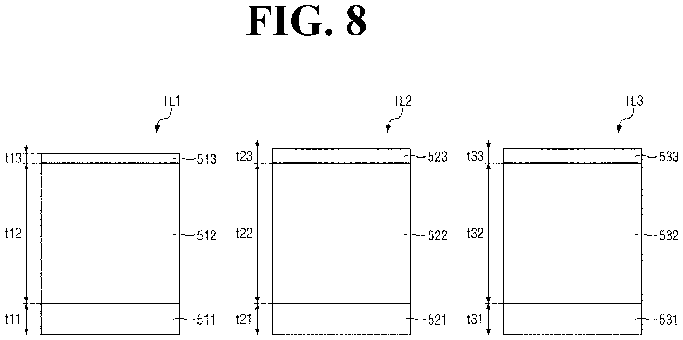

FIG. 8 is a cross-sectional view schematically showing the first inorganic film TL1, the second inorganic film TL2, and the third inorganic film TL3. In an embodiment, as shown in FIG. 8, a thickness (t11+t12+t13) of the first inorganic film TL1 may be different from a thickness (t21+t22+t23) of the second inorganic film TL2. The thickness (t21+t22+t23) of the second inorganic film TL2 may be the same as a thickness (t31+t32+t33) of the third inorganic film TL3.

Each of the first to third inorganic films TL1 to TL3 may have a multilayer structure of two or more layers. In an embodiment, each of the first to third inorganic films TL1 to TL3 may include a first layer respectively disposed on the light emitting element ED1, ED2, and ED3, a second layer disposed on the first layer, and a third layer disposed on the second layer.

Hereinafter, the first to third inorganic films TL1 to TL3 each having a structure composed of three or more layers will be described as a representative example. However, some layers may be omitted if desired, and the multilayer structure of each layer may be changed if desired.

Referring to FIGS. 5 to 7, the first inorganic film TL1 may include a first layer 511 disposed on the first light emitting element ED1, a second layer 512 disposed on the first layer 511, and a third layer 513 disposed on the second layer 512. The second inorganic film TL2 may include a first layer 521 disposed on the second light emitting element ED2, a second layer 522 disposed on the first layer 521, and a third layer 523 disposed on the second layer 522. The third inorganic film TL3 may include a first layer 531 disposed on the third light emitting element ED3, a second layer 532 disposed on the first layer 531, and a third layer 533 disposed on the second layer 532.

The first layers 511, 521, and 531 positioned at the lower portions of the first to third inorganic films TL1 to TL3 may surround the opening of the bank structure BNS, and may face the side and top surfaces of the second bank BN2. The first layers 511, 521, and 531 of the first to third inorganic films TL1 to TL3 may be in contact with the bottom surface of the tip TIP of the second bank BN2 and the side surface of the first bank BN1.

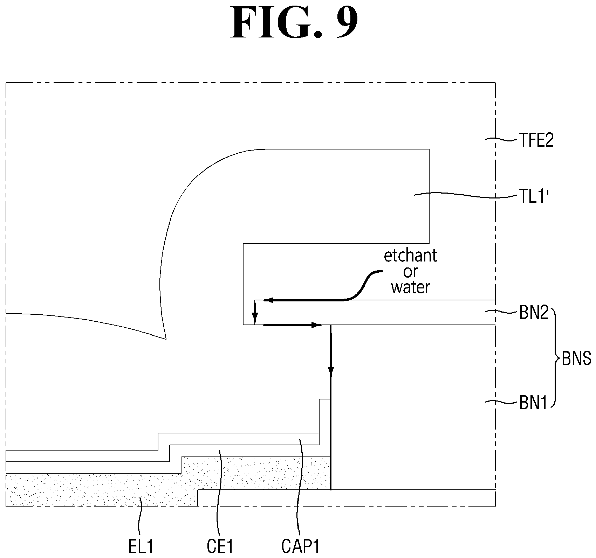

FIG. 9 is a cross-sectional view illustrating permeation of an etchant or water into the light emitting element in the display device 10. The encapsulation characteristics of a lower inorganic encapsulation film TL1' under the tip TIP of the second bank BN2 have great influence on the permeation into the light emitting element ED. In a case where the lower inorganic encapsulation film TL1' is a single layer made of a single material, the display device 10 may have high luminous efficiency and visibility change characteristics, but its encapsulation characteristics thereof may be poor. Alternatively, the encapsulation characteristics may be high, but the luminous efficiency and the visibility change characteristics may be poor.

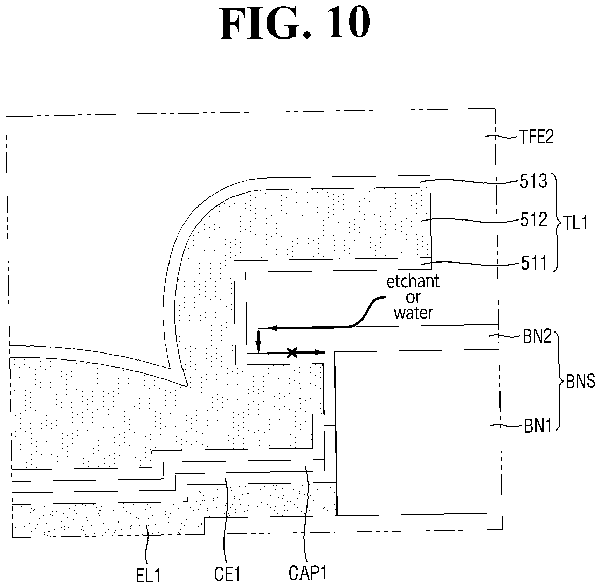

FIG. 10 is a cross-sectional view regarding permeation prevention in the display device 10 including the multi-layered lower inorganic encapsulation film TL1. When the lower inorganic encapsulation film TL1 is formed of various materials in a multilayer structure, layers may be arranged according to the properties of the materials to obtain the display device 10 improved in the encapsulation characteristics, the luminous efficiency, and the visibility change characteristics.

The first layers 511, 521, and 531 of the first to third inorganic films TL1 to TL3 in contact with the bottom surface of the tip TIP of the second bank BN2 may have a material and/or physical property with high encapsulation characteristics. As shown in FIG. 10, an etchant or water may not permeate between the tip TIP of the second bank BN2 and the first layer 511 of the first inorganic film TL1, so that permeation may be prevented. In an embodiment, the first layers 511, 521, and 531 of the first to third inorganic films TL1 to TL3 may include silicon nitride (SiNx), and may have a high refractive index.

In an embodiment, the first layers 511, 521, and 531 of the first to third inorganic films TL1 to TL3 may have a same film property as each other. The first layer 511 of the first inorganic film TL1, the first layer 521 of the second inorganic film TL2, and the first layer 531 of the third inorganic film TL3 may have a same material, a same refractive index, and a same thickness as each other.

The second layers 512, 522, and 532 and the third layers 513, 523, and 533 disposed on the first layers 511, 521, and 531 of the first to third inorganic films TL1 to TL3, respectively, may include an appropriate material according to the physical properties desired for the emission areas EA1, EA2, and EA3.

In an embodiment where one of the first to third inorganic films TL1 to TL3 each having the multilayer structure has a different film quality from another, the multilayer structures of these two films may be different from each other. Alternatively, these two films may have a same layer structure as each other, but materials or physical properties of some of their corresponding layers may be different from each other. In an embodiment, for example, one pair of the pair of the first layers 511 and 521, the pair of the second layers 512 and 522, and the pair of the third layers 513 and 523 of the first and second inorganic films TL1 and TL2 may include a same material as each other, while another pair thereof may include different materials. Alternatively, one pair of the pair of the first layers 511 and 521, the pair of the second layers 512 and 522, and the pair of the third layers 513 and 523 of the first and second inorganic films TL1 and TL2 may include a same material as each other, but may have different physical properties (e.g., thickness, refractive index, etc.) from each other.

In an embodiment, two films of the first to third inorganic films TL1 to TL3 may have a same film quality as each other, and the other film of the first to third inorganic films TL1 to TL3 may have a different film quality from the two films. The two films having the same film quality may have a same multilayer structure, and the material and the physical property of each layer of the two films may be the same as each other. In an embodiment, for example, the second inorganic film TL2 and the third inorganic film TL3 may have a same film quality as each other, and may include a same first layer 521 and 531, a same second layer 522 and 532, and a same third layer 523 and 533.

The second layers 512, 522, and 532 of the first to third inorganic films TL1 to TL3 may have thicknesses t12, t22, and t32 significantly larger than the thicknesses t11, t21, and t31 of the first layers 511, 521, and 531, and the thicknesses t13, t23, and t33 of the third layers 513, 523, and 533, respectively. The thickness t12 of the second layer 512 of the first inorganic film TL1 may be larger than the sum of the thicknesses (t11+t13) of the first layer 511 and the third layer 513 thereof, the thickness t22 of the second layer 522 of the second inorganic film TL2 may be larger than the sum of the thicknesses (t21+t23) of the first layer 521 and the third layer 523 thereof, and the thickness t32 of the second layer 532 of the third inorganic film TL3 may be larger than the sum of the thicknesses (t31+t33) of the first layer 531 and the third layer 533 thereof. The second layers 512, 522, and 532 of the first to third inorganic films TL1 to TL3 may affect the main physical properties of the lower inorganic encapsulation films TL1, TL2, and TL3, respectively.

In an embodiment, the second layer 512 of the first inorganic film TL1 may include a material and/or physical property for improving lifespan, and the second layer 522 of the second inorganic film TL2 and/or the second layer 532 of the third inorganic film TL3 may include a material and/or physical property for improving luminous efficiency and visibility. In such an embodiment, the first light emitting layer EL1 disposed below the first inorganic film TL1 may emit blue light, the second light emitting layer EL2 disposed below the second inorganic film TL2 may emit green light, and the third light emitting layer EL3 disposed below the third inorganic film TL3 may emit red light. Physical properties of the second layers 512, 522, and 532 of the first to third inorganic films TL1 to TL3 may be different from each other, or the second layer 522 of the second inorganic film TL2 and the second layer 532 of the third inorganic film TL3 may have a same physical property and a same material as each other while only the second layer 512 of the first inorganic film TL1 may have a physical property and/or a material different from those of the second layer 522 of the second inorganic film TL2 and the second layer 532 of the third inorganic film TL3.

In an embodiment, the second layer 512 of the first inorganic film TL1 may include silicon nitride (SiNx), and the second layer 522 of the second inorganic film TL2 and the second layer 532 of the third inorganic film TL3 may include silicon oxynitride (SiOxNy). The refractive index of the second layer 512 of the first inorganic film TL1 may be different from the refractive index of the second layer 522 of the second inorganic film TL2 and the refractive index of the second layer 532 of the third inorganic film TL3. The second layer 512 of the first inorganic film TL1 may have a higher refractive index than the second layer 522 of the second inorganic film TL2 and the second layer 532 of the third inorganic film TL3. The second layer 522 of the second inorganic film TL2 may have a same refractive index as the second layer 532 of the third inorganic film TL3, or may have a lower refractive index than the second layer 532 of the third inorganic film TL3. The second layers 512, 522, and 532 of the first to third inorganic films TL1 to TL3 may have a same or similar thickness, but the disclosure is not limited thereto.

The third layers 513, 523, and 533 of the first to third inorganic films TL1 to TL3 may be disposed on the second layers 512, 522, and 532, respectively. The third layers 513, 523, and 533 of the first to third inorganic films TL1 to TL3 may have a refractive index lower than that of the second layers 512, 522, and 532, so that luminous efficiency may be improved. Physical properties of the third layers 513, 523, and 533 of the first to third inorganic films TL1 to TL3 may be different from each other, or the third layer 523 of the second inorganic film TL2 and the third layer 533 of the third inorganic film TL3 may have a same physical property as each other while only the third layer 513 of the first inorganic film TL1 may have a physical property different from that of the third layer 523 of the second inorganic film TL2 and the third layer 533 of the third inorganic film TL3.

In an embodiment, the third layers 513, 523, and 533 of the first to third inorganic films TL1 to TL3 may include silicon oxynitride (SiOxNy). The refractive index of the third layer 513 of the first inorganic film TL1 may be different from the refractive index of the third layer 523 of the second inorganic film TL2 and the refractive index of the third layer 533 of the third inorganic film TL3. The third layer 513 of the first inorganic film TL1 may have a higher refractive index than the third layer 523 of the second inorganic film TL2 and the third layer 533 of the third inorganic film TL3. The third layer 523 of the second inorganic film TL2 may have a same refractive index as the third layer 533 of the third inorganic film TL3, or may have a lower refractive index than the third layer 533 of the third inorganic film TL3. The third layer 513 of the first inorganic film TL1 may have a same or similar thickness as the third layer 523 of the second inorganic film TL2 and the third layer 533 of the third inorganic film TL3. Alternatively, the thickness t13 of the third layer 513 of the first inorganic film TL1 may be smaller than the thickness t23 of the third layer 523 of the second inorganic film TL2 and the thickness t33 of the third layer 533 of the third inorganic film TL3.

In an embodiment, the first layer 511 of the first inorganic film TL1, the first layer 521 of the second inorganic film TL2, the first layer 531 of the third inorganic film TL3, and the second layer 512 of the first inorganic film TL1 may include a same material or substance as each other. The second layer 522 of the second inorganic film TL2, the second layer 532 of the third inorganic film TL3, the third layer 513 of the first inorganic film TL1, the third layer 523 of the second inorganic film TL2, and the third layer 533 of the third inorganic film TL3 may include a same material or substance as each other, and may include a material or substance different from that of the first layer 511 of the first inorganic film TL1 described above. Even when multiple layers include a same material or substance as each other, their physical properties may be different depending on a formation process therefor.

In an embodiment, the refractive index of the first layer 511 of the first inorganic film TL1 and the refractive index of the second layer 512 of the first inorganic film TL1 may be equal or similar to each other. In another embodiment, a difference between the refractive index of the first layer 511 of the first inorganic film TL1 and the refractive index of the second layer 512 of the first inorganic film TL1 may be within 0.1. In the specification, the refractive index is defined with respect to the visible light region (e.g., 380 nm to 720 nm).

In an embodiment, each of the first layer 511 of the first inorganic film TL1, the first layer 521 of the second inorganic film TL2, the first layer 531 of the third inorganic film TL3, and the second layer 512 of the first inorganic film TL1 may have a refractive index in a range of 1.8 to 2.0, and their refractive indices may be equal to or different from each other.

In an embodiment, each of the second layer 522 of the second inorganic film TL2, the second layer 532 of the third inorganic film TL3, the third layer 513 of the first inorganic film TL1, the third layer 523 of the second inorganic film TL2, and the third layer 533 of the third inorganic film TL3 may have a refractive index in a range of 1.4 to 1.8 or a refractive index in a range of 1.5 to 1.78, and their refractive indices may be equal to or different from each other. The third layer 513 of the first inorganic film TL1 may have a refractive index higher than that of the second layer 522 of the second inorganic film TL2. The third layer 533 of the third inorganic film TL3 may have a refractive index equal to or similar to that of the second layer 522 of the second inorganic film TL2. The third layer 523 of the second inorganic film TL2 may have a lower refractive index than the second layer 512 of the first inorganic film TL1, the second layer 522 of the second inorganic film TL2, the second layer 532 of the third inorganic film TL3, the third layer 513 of the first inorganic film TL1, and the third layer 533 of the third inorganic film TL3.

In an embodiment, the third layer 513 of the first inorganic film TL1 may have a refractive index lower than that of the second layer 532 of the third inorganic film TL3. In another embodiment, the third layer 513 of the first inorganic film TL1 may have a higher refractive index than the second layer 522 of the second inorganic film TL2 and the second layer 532 of the third inorganic film TL3.

In an embodiment, a first layer disposed in one film may have a higher refractive index than a second layer and a third layer of the one film, and the second layer of the corresponding film may have a refractive index higher than that of the third layer.

The thicknesses 111, t21, and t31 of the first layers 511, 521, and 531 of the first to third inorganic films TL1 to TL3 may be smaller than the thicknesses 112, t22, and t32 of the second layers 512, 522, and 532, but may be larger than the thicknesses t13, t23, and t33 of the third layers 513, 523, and 533, respectively.

In the specification, the refractive index may be measured using an optical measuring instrument such as an ellipsometer, a spectral reflectometer, or the like. The ellipsometer may measure the refractive index by measuring the amount of change in polarization of incident light and reflected light with respect to the inorganic film and calculating the thickness and complex refractive index of the inorganic film. The spectral reflectometer may measure the refractive index of the inorganic film by comparing the intensity of light acquired by changing the wavelength. In the specification, the thickness may be measured with an X-ray reflectometer (XRR) (D8 ADVANCE Plus manufactured by Bruker), or measured with a TEM or a SEM. The thickness and the refractive index may be values measured at normal temperature and pressure.

The organic encapsulation film TFE2 is disposed on the second bank BN2 and the lower inorganic encapsulation films TL1, TL2, and TL3. Portions of the organic encapsulation film TFE2 may be disposed between the top surface of the second bank BN2 and the first layers 511, 521, and 531 of the lower inorganic encapsulation films TL1, TL2, and TL3.

The organic encapsulation film TFE2 may be in contact with the second bank BN2. The second bank BN2 in an area overlapping the light emitting layers EL1, EL2, and EL3 in the thickness direction DR3 of the substrate may be in contact with the organic encapsulation film TFE2.

Portions of the organic encapsulation film TFE2 may be disposed between the lower inorganic encapsulation films TL1, TL2, and TL3 and the side surface of the second bank BN2. The side surface of the second bank BN2 may be in contact with the organic encapsulation film TFE2 or the first layers 511, 521, and 531 of the lower inorganic encapsulation films TL1, TL2, and TL3.

The upper inorganic encapsulation film TFE3 may be disposed on the organic encapsulation film TFE2. The upper inorganic encapsulation film TFE3 may include at least one selected from aluminium oxide, titanium oxide, tantalum oxide, hafnium oxide, zinc oxide, silicon oxide, silicon nitride, and silicon oxynitride.

A light blocking layer (not shown) may be selectively disposed on the thin film encapsulation layer TFEL. The light blocking layer may be positioned between the emission areas EA1, EA2, and EA3. The light blocking layer may include a light absorbing material. In an embodiment, for example, the light blocking layer may include an inorganic black pigment or an organic black pigment. The inorganic black pigment may be carbon black, and the organic black pigment may include at least one selected from lactam black, perylene black, and aniline black, but not being limited thereto. The light blocking layer may prevent visible light infiltration and color mixture between the first to third emission areas EA1, EA2, and EA3, which leads to the improvement of color reproducibility of the display device 10.

The display device 10 may include the plurality of color filters CF1, CF2, and CF3 disposed on the emission areas EA1, EA2, and EA3. Each of the plurality of color filters CF1, CF2, and CF3 may include a filtering pattern area and a light blocking area. The filtering pattern areas may be formed to overlap the emission areas EA1, EA2, and EA3, or the openings of the bank structures BNS, and may form a light exit area from which the light emitted from the emission areas EA1, EA2, and EA3 is emitted. The light blocking area is an area in which the plurality of color filters CF1, CF2, and CF3 are stacked so that light cannot be transmitted.

The color filters CF1, CF2, and CF3 may include a first color filter CF1, a second color filter CF2, and a third color filter CF3 disposed to correspond to the different emission areas EA1, EA2, and EA3, respectively. The color filters CF1, CF2, and CF3 may include a colorant such as a dye or a pigment that absorbs light in a wavelength band other than a specific wavelength band, and may be disposed to correspond to the color of the light emitted from the emission areas EA1, EA2, and EA3. In an embodiment, for example, the first color filter CF1 may be a blue color filter that is disposed to overlap the first emission area EA1 and transmits only the first light of the blue color. The second color filter CF2 may be a green color filter that is disposed to overlap the second emission area EA2 and transmits only the second light of the green color, and the third color filter CF3 may be a red color filter that is disposed to overlap the third emission area EA3 and transmits only the third light of the red color.

In an embodiment of the display device 10, the color filters CF1, CF2, and CF3 are disposed to overlap each other, so that the intensity of the reflected light by external light may be reduced. Furthermore, the color of the reflected light by the external light may be controlled by adjusting the disposition, shape, and area of the color filters CF1, CF2, and CF3 in plan view.

The overcoat layer OC may be disposed on the color filters CF1, CF2, and CF3 to planarize the top ends of the color filters CF1, CF2, and CF3. The overcoat layer OC may be a colorless light transmissive layer that does not have a color in a visible light band. In an embodiment, for example, the overcoat layer OC may include a colorless light transmissive organic material such as an acrylic resin.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device comprising:
a first pixel electrode and a second pixel electrode disposed to be spaced apart from each other on a substrate;
a pixel defining layer disposed on the substrate, wherein the pixel defining layer exposes the first pixel electrode and the second pixel electrode;
a first light emitting layer disposed on the first pixel electrode, and a second light emitting layer disposed on the second pixel electrode;
a first common electrode disposed on the first light emitting layer, and a second common electrode disposed on the second light emitting layer and spaced apart from the first common electrode;
a first bank disposed on the pixel defining layer;
a second bank disposed on the first bank, wherein a side surface of the second bank protrudes more than a side surface of the first bank;
a first inorganic film disposed on the first common electrode and the second bank, and spaced apart from a top surface of the second bank; and
a second inorganic film disposed on the second common electrode and the second bank, and spaced apart from the top surface of the second bank and the first inorganic film,
wherein a film quality of the first inorganic film and a film quality of the second inorganic film are different from each other.

2. The display device of claim 1, wherein the first inorganic film and the second inorganic film are different from each other in at least one selected from thickness, material, and refractive index.

3. The display device of claim 1 or claim 2, wherein each of the first inorganic film and the second inorganic film comprises a first layer, a second layer, and a third layer, which are sequentially stacked therein, and
the first layer of the first inorganic film and the first layer of the second inorganic film are in contact with a side surface of the first bank.

4. The display device of claim 3, wherein one pair among a pair of first layers, a pair of second layers, and a pair of third layers of the first inorganic film and the second inorganic film comprises a same material as each other, and
another pair among the pair of first layers, the pair of second layers, and the pair of third layers of the first inorganic film and the second inorganic film comprises different materials, respectively.

5. The display device of claim 3 or claim 4, wherein the second layer of the first inorganic film comprises silicon nitride, and
the second layer of the second inorganic film comprises silicon oxynitride, optionally wherein the first light emitting layer emits blue light, and
the second light emitting layer emits red light or green light.

6. The display device of any one of claims 3 to 5, wherein the first layer of the first inorganic film comprises a same material as the second layer of the first inorganic film and the first layer of the second inorganic film, and
the first layer of the first inorganic film comprises a material different from a material of the third layer of the first inorganic film and the second layer of the second inorganic film.

7. The display device of any one of claims 3 to 6, wherein a refractive index of the second layer of the first inorganic film is greater than a refractive index of the second layer of the second inorganic film, and
a refractive index of the first layer of the second inorganic film is greater than a refractive index of the second layer of the second inorganic film, optionally wherein a refractive index of the first layer of the first inorganic film and the refractive index of the second layer of the first inorganic film are equal to each other, or
a difference between the refractive index of the first layer of the first inorganic film and the refractive index of the second layer of the first inorganic film is equal to or less than 0.1.

8. The display device of any one of claims 1 to 7, wherein a thickness of the first inorganic film and a thickness of the second inorganic film are different from each other.

9. The display device of any one of claims 3 to 8, wherein a thickness of the second layer of the first inorganic film is greater than a sum of a thickness of the first layer of the first inorganic film and a thickness of the third layer of the first inorganic film.

10. The display device of any one of claims 3 to 9, wherein:
(i) the first layer of the first inorganic film comprises a same material as the first layer of the second inorganic film, and
the first layer of the first inorganic film has a same refractive index, and a same thickness as the first layer of the second inorganic film; and/or
(ii) the first layer of the first inorganic film and the first layer of the second inorganic film face the side surface of the first bank, a side surface of the second bank, and the top surface of the second bank.

11. The display device of any one of claims 1 to 10, further comprising an organic encapsulation film disposed between the first inorganic film and the top surface of the second bank, and between the second inorganic film and the top surface of the second bank.

12. A display device of claim 1, further comprising:
a third pixel electrode disposed to be spaced apart from the first pixel electrode and the second pixel electrode on the substrate, wherein the pixel defining layer exposes the third pixel electrode;
a third light emitting layer disposed on the third pixel electrode;
a third common electrode disposed on the third light emitting layer and spaced apart from the second common electrode; and
a third inorganic film disposed on the third common electrode and the second bank, and spaced apart from the top surface of the second bank, the first inorganic film, and the second inorganic film,
wherein the first inorganic film has a film quality different from a film quality of the third inorganic film.

13. The display device of claim 12, wherein the film quality of the second inorganic film and the film quality of the third inorganic film are different from each other.

14. The display device of claim 13, wherein each of the first inorganic film, the second inorganic film, and the third inorganic film comprises a first layer, a second layer, and a third layer, which are sequentially stacked therein, and
the second layer of the first inorganic film, the second layer of the second inorganic film, and the second layer of the third inorganic film have refractive indices different from each other, optionally wherein the third layer of the first inorganic film, the third layer of the second inorganic film, and the third layer of the third inorganic film comprise a same material as each other, and
the third layer of the first inorganic film, the third layer of the second inorganic film, and the third layer of the third inorganic film have refractive indices different from each other.

15. The display device of claim 12, wherein the film quality of the third inorganic film is the same as the film quality of the second inorganic film, optionally wherein each of the first inorganic film, the second inorganic film, and the third inorganic film comprises a first layer, a second layer, and a third layer, which are sequentially stacked therein, and
the first layer, the second layer and the third layer of the second inorganic film are the same as the first layer, the second layer and the third layer of the third inorganic film, respectively.
